# EUROPEAN PATENT SPECIFICATION

(11) **EP 1 403 987 B1**
(45) Date of publication and mention of the grant of the patent: **03.05.2006**
(21) Application number: 03021180.9
(22) Date of filing: 24.09.2003
(51) Int. Cl.: H01S 5/183

(54) **VCSEL with a reflection layer made of resin for single transverse mode emission**
VCSEL mit einer reflektierenden Schicht aus Harz zur Emission einer transversalen Mode
VCSEL avec une couche de reflexion en résine pour une émission monomode transversale

(30) Priority: 25.09.2002 JP 2002279066
(43) Date of publication of application: 31.03.2004
(73) Proprietor: SEIKO EPSON CORPORATION, Shinjuku-ku, Tokyo 163-0811 (JP)
(72) Inventor: Kaneko, Tsuyoshi c/o Seiko Epson, Suwa-shi Nagano-ken 392-8502 (JP)
(74) Representative: Hoffmann, Eckart

(56) References cited:
- EP-A- 1 130 720
- WO-A-02/45217
- US-A1- 2002 127 754
- US-B1- 6 185 241
- MORGAN R A ET AL: "HYBRID DIELECTRIC/ALGAAS MIRROR SPATIALLY FILTERED VERTICAL CAVITY TOP-SURFACE EMITTING LASER" APPLIED PHYSICS LETTERS, AMERICAN INSTITUTE OF PHYSICS. NEW YORK, US, vol. 66, no. 10, 6 March 1995 (1995-03-06), pages 1157-1159, XP000503633 ISSN: 0003-6951
- SCHAEFER R R: "METHOD FOR FABRICATING POLYIMIDE FILMS" IBM TECHNICAL DISCLOSURE BULLETIN, IBM CORP. NEW YORK, US, vol. 25, no. 3A, August 1982 (1982-08), pages 1162-1163, XP000806741 ISSN: 0018-8689
- PATENT ABSTRACTS OF JAPAN vol. 013, no. 099 (E-724), 8 March 1989 (1989-03-08) -& JP 63 274187 A (SHARP CORP), 11 November 1988 (1988-11-11)

## Description

The present invention relates to a surface emitting semiconductor laser, a manufacturing method thereof, and a light module and a light transmission device including the surface emitting semiconductor laser.

A surface emitting semiconductor laser is greatly expected as a light source for optical communication and optical computing and various kinds of sensor. In the optical communication, a surface emitting semiconductor laser is currently tried to be applied to a light source for the short distance optical communication used with a multi-mode fiber. Further, a surface emitting semiconductor laser will be applied as a light source for the long distance optical communication used with a single-mode fiber in the future.

A transversal mode is a single-mode (zero order fundamental mode), as a characteristic of a light source, which is suitable for a single-mode fiber. Therefore, when applying a surface emitting semiconductor laser as a light source using a single-mode fiber, a stable single mode is required.

As one of methods of obtaining light of a single mode with a surface emitting semiconductor laser, it is well known that a current aperture is formed by selective oxidation and light is blocked at the same time of narrowing electric current by the current aperture. For example, in a surface emitting semiconductor laser composed of the AlGaAs series, a layer having a high proportion of aluminum is formed in a multi-layered film mirror in advance and the side of this layer is oxidized thereafter so as to form the current aperture. This current aperture comprises a region in the center where the high proportion of Al remained (an aperture) and an outskirt region including aluminum oxide (an oxidation blocking portion) which is formed around the above region. However, according to this method, there is a concern that the effect of blocking light is too large since the difference between the refractive index of the aperture and that of the oxidation-blocking portion is too large. Hence, it is desirable that the radius of the aperture is under 4 µm in order to obtain a stable single mode. However, in this case, there is the other concern that the element resistance is increased by restricting the electric current path in addition to deteriorating the light emission efficiency.

A surface emitting semiconductor laser as defined in the pre-characterizing portion of claim 1 is known from the document Applied Physics Letters, American Institute of Physics, New York, US, (06-03-1995), 66(10), 1157-1159. In this prior art the upper part of the second mirror includes 5 SiO₂/TiO₂ layer pairs with an additional λ/2 top SiO₂ layer and has a conservatively designed reflectivity of about 99,8%. The document does not mention any layer on the second mirror, i.e., a layer of the λ/2 top SiO₂ layer.

WO 02/45217 A2 discloses a surface emitting semiconductor laser including a resonator formed on a substrate and emitting a laser beam in a direction perpendicular to the substrate from an emitting surface formed on the upper surface of the resonator, wherein the resonator includes on the substrate a first mirror, an active layer and a second mirror, the first mirror and the second mirror sandwiching the active layer. A reflectivity adjustment layer structure composed of two layer is formed on the emitting surface. The first (lower one) of the two layers has a thickness of λ/4 and both layers together have a thickness of λ/2. The second layer is substantially regeistered with the emitting surface and the first mirror has an area lager than that of the second layer. The effective mirror reflectivity under the first layer is reduced and optical loss is increased, except for the area under the second layer, where the mirror reflectivity is either unaffected or enhanced, depending upon the material used to form the second layer. This serves to strengthen single mode selection and output.

It is an object of the present invention to provide a surface emitting semiconductor laser being capable of controlling a stabilized transversal mode, and a method of manufacturing it.

In addition, the present invention is to provide a light module and a light transmission device including the surface emitting semiconductor laser.

These objects are achieved by a semiconductor laser as claimed in claim 1 and a method of manufacturing it as claimed in claim 17. Preferred embodiments of the invention are subject-matter of the dependent claims.

In this application, "optical thickness" is defined as a value obtained by dividing the refractive index from the actual thickness of the layer. For example, when the wavelength of a laser beam is A, the optical thickness is λ/2 and the refractive index n is 1.4, the actual thickness of the layer is λ/2 x 1.4=0.7λ since it is equal to an optical thickness multiplied by the refractive index "n". In addition, in the present application, it is assumed that merely saying "thickness" means the actual thickness.

In addition, "emitting light in a direction perpendicular " to a substrate" means "emitting light in a direction perpendicular to the installed surface of the resonator".

In one embodiment of the present invention, the refractive index of the region comprising the reflectivity adjustment layer and the region of the second mirror below the reflectivity adjustment layer is smaller than the refractive index of the other region.

In other words, when a region comprising the reflectivity adjustment layer and a region of the second mirror below the reflectivity adjustment layer is defined as a first region, the other region except the first region in the second mirror is defined as a second region, the reflectivity for the laser beam in the first region can be larger than the reflectivity for the laser beam in the second region.

Hence, the threshold value of a laser oscillation in the first region can be decreased compared with that of the second region, such that light having a stable transversal mode can be attained.

According to one embodiment of the present invention, at least a part of the first electrode is formed on the upper surface of the resonator, an aperture is formed on the upper surface of the resonator, and the reflectivity adjustment layer is formed on the emitting surface installed within the aperture. Hence, the layer for the first electrode is different from the reflectivity adjustment layer, enabling the configuration and size of the first electrode to be formed independently from that of the reflectivity adjustment layer so as to enhance versatility of element design.

Preferred embodiments of the present invention are described with referring to the accompanying drawings as follows.
- Fig.1: is a schematic sectional view of a surface emitting semiconductor laser according to a first embodiment of the present invention.
- FIG. 2: is a plan view showing the surface emitting semiconductor laser of the first embodiment.
- FIG. 3: is an expanded schematic sectional view of the second mirror shown in FIG. 1.
- FIG. 4: is a schematic sectional view showing a process for manufacturing the surface emitting semiconductor laser shown in FIG. 1 to FIG. 3.
- FIG. 5: is a schematic sectional view showing a process for manufacturing the surface emitting semiconductor laser shown in FIG. 1 to FIG. 3.
- FIG. 6: is a schematic sectional view showing a process for manufacturing the surface emitting semiconductor laser shown in FIG. 1 to FIG. 3.
- FIG. 7: is a schematic sectional view showing a process for manufacturing the surface emitting semiconductor laser shown in FIG. 1 to FIG. 3.
- FIG. 8: is a schematic sectional view showing a process for manufacturing the surface emitting semiconductor laser shown in FIG. 1 to FIG. 3.
- FIG. 9: is a schematic sectional view showing a process for manufacturing the surface emitting semiconductor laser shown in FIG. 1 to FIG. 3.
- FIG. 10: is a schematic sectional view showing a process for manufacturing the surface emitting semiconductor laser shown in FIG. 1 to FIG. 3.
- FIG. 11: is a schematic sectional view showing a surface emitting semiconductor laser according to a second embodiment of the present invention.
- FIG. 12: is a schematic sectional view showing a surface emitting semiconductor laser of the second embodiment.
- FIG. 13: is an expanded schematic sectional view showing the second mirror shown in FIG. 11.
- FIG. 14: is a schematic sectional view showing a surface emitting semiconductor laser according to a third embodiment of the present invention.
- FIG. 15: is a schematic plan view showing the surface emitting semiconductor laser of the third embodiment.
- FIG. 16: is a schematic view showing a light module according to a fourth embodiment of the present.
- FIG. 17: is a diagram showing a light transmission device according to a fifth embodiment of the present invention.
- FIG. 18: is a diagram showing a usage of the light transmission device of the fifth embodiment.
- FIG. 19: is a diagram showing a usage of the light transmission device of the fifth embodiment.
- FIG. 20: is a diagram showing a usage of a light transmission device according to a sixth embodiment of the present invention.
- FIG. 21: is a diagram showing the reflectivity of the first and the second regions 191and 192 in the second mirror 104 in the experiment example.

### First Embodiment

### 1. Structure of the surface emitting semiconductor laser

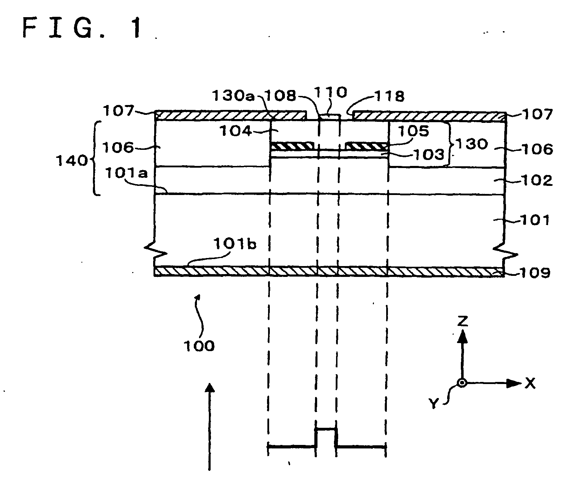

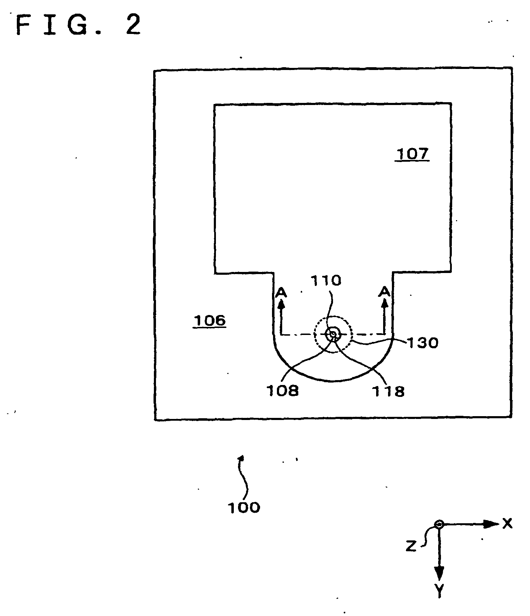

Fig. 1 is a sectional view schematically showing a surface emitting semiconductor laser (simply referred to as "surface-emitting laser") 100 of a first embodiment to which the present invention is applied. Fig. 2 is a plan view showing the surface- emitting laser 100 schematically. FIG.1 shows a section along the A-A line of FIG. 2.

The surface-emitting laser 100 of the present embodiment comprises a substrate 101 (n-type GaAs substrate in this embodiment) and a vertical resonator 140 (simply referred as to a "resonator" hereafter) formed on the substrate 101, as shown in FIG. 1. The surface-emitting laser 100 can emit a laser beam from the emitting surface 108, which is formed on the upper surface of the resonator 140 in a direction perpendicular to the substrate 101.

Next, each of constituents of this surface emitting semiconductor laser 100 is described.

In this embodiment, the resonator 140 includes a column-like semiconductor stacked layer 130 (referred to as column-like portion); the side of the column-like portion 130 is covered by an insulating layer 106.

The column-like portion 130 is formed in the resonator 140. Here, the column-like portion 130 is one part of the resonator 140 and includes a second mirror 104. This column-like portion 130 is buried with an insulation layer 106. In other words, the side of the column-like portion 130 is surrounded by the insulation layer 106. Furthermore, a first electrode 107 is formed on the column-like portion 130 and the surrounding insulation layer 106.

The resonator 140 comprises, for example, a distributed reflection-type multi-layered mirror 102 (referred to as a first mirror hereafter), formed by depositing 40 pairs of an n-type Al_{0.9}Ga_{0.1}As layer and an n-type Al_{0.15}Ga_{0.85}As layer each, an active layer 103 including a quantum well structure constituted by triple GaAs well layers and a Al_{0.3}Ga_{0.7}As barrier layer, and a distributed reflection-type multi-layered mirror 104 (referred to as a second mirror hereafter), formed by depositing 25 pairs of a p-type Al_{0.8}Ga_{0.1}As layer an a p-type Al_{0.15}Ga_{0.85}As layer each, which are deposited sequentially in this order. Further, the composition and number of layers in the first mirror 102, the active layer 103 and the second mirror 104 are not limited to those mentioned above.

Each of layers constituting the first mirror has an optical thickness (the thickness in the direction parallel to Z direction shown in FIG.1) which is an odd multiple of λ/4 (for example, λ/4) when the wavelength of a laser beam emitted from the emitting surface 108 is λ.

In addition, the second mirror 104 includes a layer having an optical thickness of m₁·λ/2 (m₁, natural number), and each of layers except this layer, composing the second mirror 104 has an optical thickness which is an odd multiple of λ/4 (for example, λ/4). In the present embodiment, a case is described where the layer whose optical thickness is m₁·λ/2, is the top layer of the second mirror 104.

Impurity of the second mirror 104 is p-type by doping C, for example, impurity in the first mirror 102 is n-type by doping Si, for example. Therefore, a PIN diode is formed by the second mirror 104, the non-doped active layer 103 and the first mirror 102.

According to the present embodiment, a portion of the resonator 140 between the emitting surface and the first mirror 102 is etched to a circular shape as viewed from the emitting surface so as to form the column-like portion 130. Hence, in this embodiment, the plane shape of this column-like portion 130 is a circle. But, arbitrary other shapes for this portion are also possible.

Furthermore, in a region of the layers constituting the second mirror 104 that is near to the active layer 103, a current aperture 105 composed of an aluminum oxide can be formed. This current aperture 105 is formed in a ring-shape. Namely, this current aperture 105 has a concentric circular ring-shaped in plan view. In other words, the sectional shape of this current aperture 105 in a plane parallel to the X-Y plane in FIG. 1, is a concentric circular ring-shape.

The area of the inside circle of the current aperture 105 can be made larger than the sectional area of a reflectivity adjustment layer 110 (described below). According to this structure, the resistance value of an element caused by current aperture 105 can be made small so as to enhance light emission efficiency. Furthermore, the current aperture 105 is formed so as to control the current path independently from controlling the transversal mode. As a result, a surface emitting semiconductor laser with high efficiency and high reliability can be obtained.

In addition, in the surface-emitting laser 100 of the preferred embodiment, the insulation layer 106 is formed to cover the side surface of the column-like portion 130 as well as the upper surface of the first mirror 102.

In a process of manufacturing the surface-emitting laser 100, the insulation layer 106 is formed to cover the side surface of the column-like portion 130. Subsequently, the first electrode 107 is formed on the upper surface of the column-like portion 130 and the upper surface of the insulating layer 106. A second electrode 109 is formed on the backside surface 101b of the substrate 101. In the process of forming these electrodes, an annealing treatment is generally implemented at about 400 °C (refer to the manufacturing process described below). Therefore, when the insulation layer 106 is formed from resin, it is necessary that the resin is sufficiently temperature resistant to endure the annealing process. In order to satisfy this requirement, it is desirable that a resin such as a polyimide resin, a fluorine group resin, an acrylic acid resin or an epoxy resin is used for the insulation layer 106. Especially, a polyimide resin is desirable viewed from easiness in processing and insulation.

The first electrode 107 and the second electrode 109 are arranged in order to inject a current into the resonator 140, more specifically, into the active layer 103.

At least a part of the first electrode 107, as shown in FIG. 1, is formed on the upper surface of the column-like portion 130. In detail, the first electrode 107 is formed on the upper surface of the column-like portion 130 and the insulation layer 106. The first electrode 107 can be formed as a multi-layered film such as an alloy of Au and Zn and Au, for example.

The first electrode 107 has an aperture 118 above the upper surface 130a of the resonator 130. In other words, in the central portion of the upper surface 130a of the column-like portion 130, there is a part (the aperture 118) where the first electrode 107 is not formed. The emitting surface 108 for emitting a laser beam is formed within the aperture 118.

In the surface-emitting laser 100 of the present embodiment, the emitting surface 108 is circular.

Furthermore, on the backside 101b of the substrate 101, the second electrode 109 is formed. In other words, for connecting the surface-emitting laser 100 shown in FIG. 1, the first electrode 107 on the column-like portion 130 and the second electrode 109 at the backside 101b of the substrate 101 are used. The second electrode 109 can be formed as a multi-layered film such as an alloy of Au and Ge and Au, for example.

A reflectivity adjustment layer 110 is formed on the emitting surface 108. The plane configuration of the reflectivity adjustment layer 110 can be circular. In this case, the diameter of the reflectivity adjustment layer 110 can be less than 6 µm. According to this structure, it is uneasy to generate a laser beam with a high order mode such that a stable laser beam with single mode can be easily obtained. Hence, this can be applied to a light source with a single-mode fiber for optical communication. In addition, in this case, the central axis of the reflectivity adjustment layer 110 can be made to be coaxial with the central axis of the emitting surface 108. According to this constitution, a stable laser beam with circular transversal mode can be obtained.

In addition, this reflectivity adjustment layer 110 can be formed from a material transparent to the laser beam emitted from the emitting surface 108. Hence, the reflectivity adjustment layer 110 is composed of a material transparent to the laser beam enabling the laser beam to be emitted more efficiently. Thus, a surface emitting semiconductor laser with high efficiency, which can control modes, can be obtained.

The reflectivity adjustment layer 110 is formed from a liquid material for example, which can be hardened by exposing it to energy such as heat, light and others (a resin hardened by an ultraviolet ray, or a resin hardened by heat, for example). As a resin hardened by an ultraviolet ray, an acrylic group resin and an epoxy group resin, which are hardened by ultraviolet light, are cited, for example.

In addition, as a resin hardened by heat, a precursor of a polyimide group resin hardened by heat can be cited. A resin hardened by ultraviolet light is hardened by irradiating an ultraviolet ray during short time. Hence, the material can be hardened without a process that may give any damages to an element such as a thermal process. Therefore, when forming the reflectivity adjustment layer 110 by using an ultraviolet ray hardened resin, influence given to an element can be reduced.

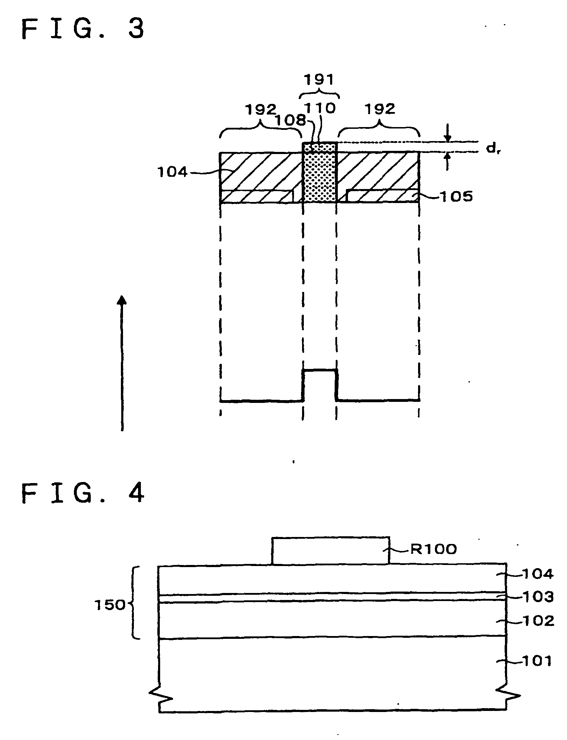

In addition, the optical thickness "d,"(see FIG. 3) of this reflectivity adjustment layer 110, is (2m₂₋1)·λ/4 (m₂, natural number).

FIG. 1 shows a sectional profile of the reflectivity of the second mirror 104 along with the surface-emitting laser 100. In addition, FIG. 3 shows an expanded sectional view of the neighborhood of the second mirror 104 in FIG. 1. As shown in FIG. 3, a region comprising the reflectivity adjustment layer 110 and the portion of the second mirror 104 below the reflectivity adjustment layer 110 are defined as a first region 191, and the region other than the first region 191 is defined as a second region 192. In detail, FIG. 3 shows a dotted region as the first region 191 and a hatched region as the second region 192. The reflectivity for the laser beam in the first region 191 is larger than that in the second region 192. FIG. 1 and FIG. 3 show a distribution of reflectivity in each of the first region 191 and in the second region 192. In FIG. 1 and FIG. 3, the reflectivity increases as the distance in the arrowed direction increases.

As described above, the second mirror 104 includes a layer whose optical thickness is m₁·λ/2; each of the layers, except this layer, that compose the second mirror 104 has an optical thickness, which is an odd multiple of λ/4. If the above case, when the second mirror 104 includes a layer whose optical thickness is m₁·λ/2 and each of the layers except this layer of the second mirror 104 has an optical thickness, which is an odd multiple of λ/4, as is the case with the surface-emitting laser 100 of the present embodiment, is compared with a case where the optical thickness of all layers of the second mirror 104 is an odd multiple of λ/4, the reflectivity of the second mirror 104 in the first mentioned case is lower. However, in this case, the reflectivity of the first region 191 can be increased by forming the reflectivity adjustment layer 110 whose optical thickness is (2m₂-1)·λ/4. Hence, the reflectivity for the laser beam in the first region 191 can be larger than the reflectivity for the laser beam in the second region 192. As a result, the first region 191 can generate laser oscillation more efficiently than the second region 192 enabling light with a single mode to be obtained efficiently.

### 2. Operation of the surface-emitting semiconductor laser

General operation of the surface-emitting laser 100 of the present embodiment is shown in the following. Here, the following method of driving the surface emitting semiconductor laser is merely one example and various kinds of modification are available within the scope of the present invention.

At first, when a forward voltage is applied to the PIN diode via the first electrode 107 and the second electrode 109, electrons are re-combined with positive holes in the active layer 103 so as to generate light emission related to this re-combination. Thus, induced emission occurs when a generated light beam goes back and forth between the second mirror 104 and the first mirror 102 so as to amplify light intensity. When the optical gain surpasses the optical loss, laser oscillation occurs so as to emit a laser beam in a direction perpendicular to the substrate 101 (the Z -direction in FIG. 1) from the emitting surface 108 on the column-like portion 130 via the reflectivity adjustment layer 110. Here, "a direction perpendicular to the substrate 101" means "a direction (the Z -direction in FIG. 1) perpendicular to the surface 101a (a plane parallel to the X-Y plane in FIG. 1) of the substrate 101".

### 3. Process for manufacturing the surface emitting semiconductor laser

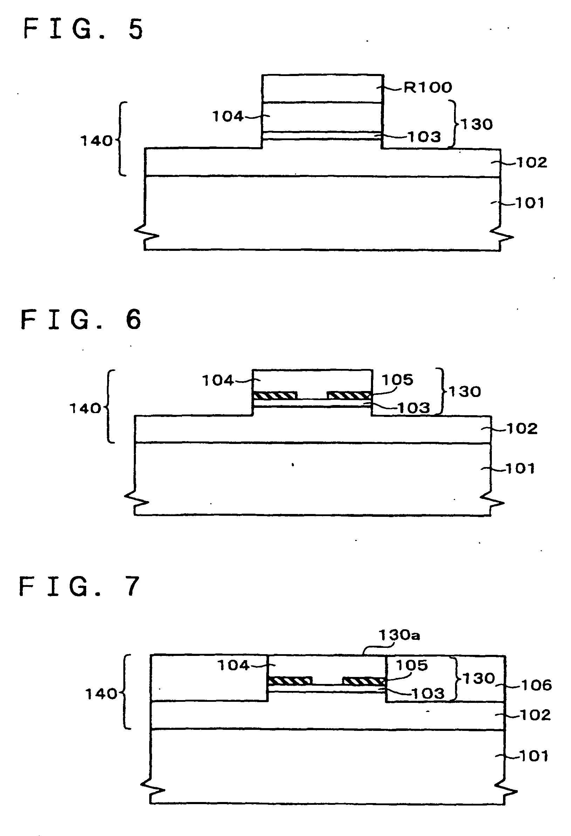

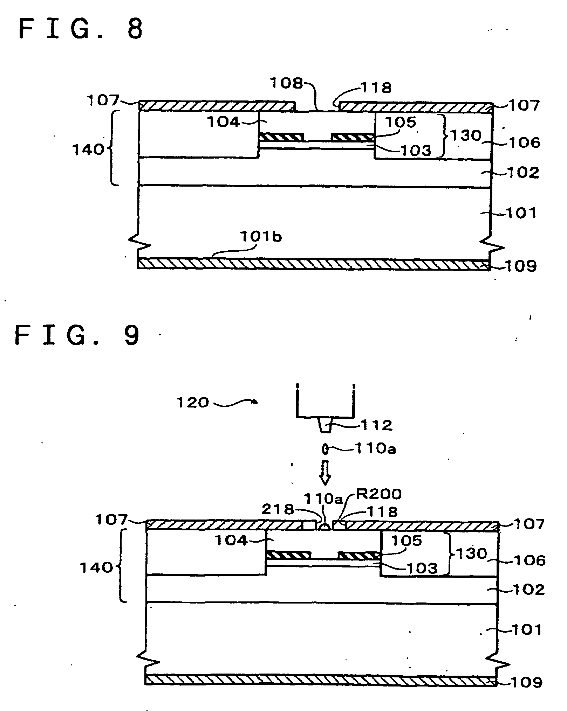

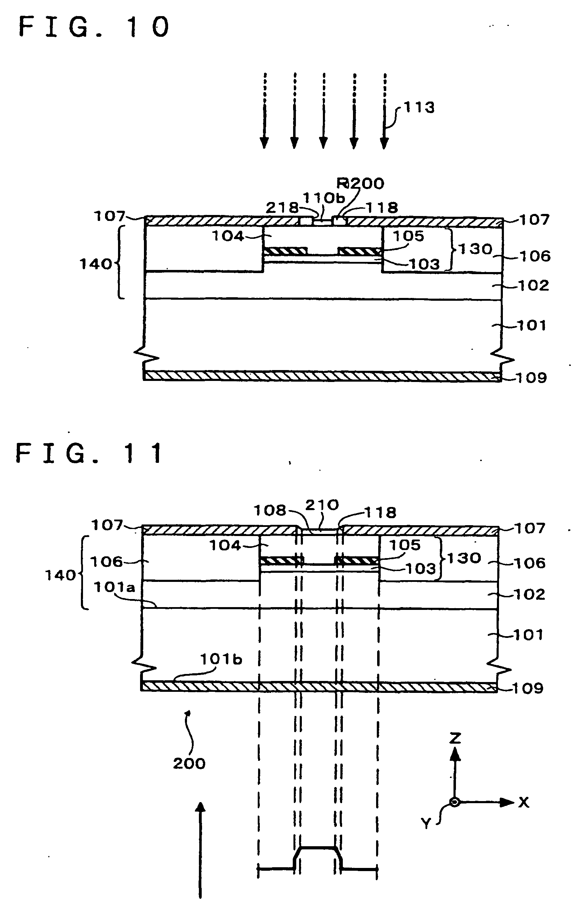

Next, an example of a method for manufacturing the surface-emitting laser 100 of the first embodiment is described referring to Fig. 4 to FIG. 10. FIG. 4 to FIG. 10 show sectional views schematically illustrating a process for manufacturing the surface emission semiconductor laser 100 of the present embodiment and correspond to the sectional view of FIG. 1.
(1) At first, a semiconductor multi-layered film 150 is formed on the n-type GaAs substrate 101 by epitaxial growth while modulating the composition (see FIG. 4).
   The semiconductor multi-layered film 150 comprises, for example, the first mirror 102, formed by depositing 40 pairs of an n-type Al_{0.9}Ga_{0.1}As layer and an n-type Al_{0.15}Ga_{0.85}As layer each so that the two kinds of layer are alternately formed, the active layer 103 including a quantum well structure constituted by triple GaAs well layers and an Al_{0.3}Ga_{0.7}As barrier layer, and the second mirror 104, formed by depositing 25 pairs of a p-type Al_{0.9}Ga_{0.1}As layer and p-type Al_{0.15}Ga_{0.85}As layer each so that the two kinds of layer are alternately formed. Only the top layer of the second mirror 104 is grown so as to have an optical thickness of m₁·λ/2. The optical thickness of the remaining layers of the second mirror 104 as well as that of all layers of the first mirror 102 is an odd multiple of λ/4 each. These layers are accumulated in order on the substrate 101 so as to form the semiconductor multi-layered film 150. Here, when growing the second mirror 104, at least one layer close to the active layer 103 is formed as an AlAs layer or an AlGaAs layer having more than 0.95 atom% Al (the layer of a high Al proportion). This layer is oxidized later to become the current aperture 105. In addition, it is desirable that the carrier density of the top surface layer of the second mirror 104 be increased so as to provide for an ohmic contact with an electrode (the electrode 107 described hereafter).
   The temperature for epitaxial growth is determined appropriately in accordance with employed growth method, raw materials, the kind of the substrate 101 or the kind of the semiconductor multi-layered film 150, its thickness and carrier density. But in general, it is desirable to be the range of 450°C to 800 °C. In addition, the time for the epitaxial growth is also determined appropriately like the temperature.
   As a method of epitaxial growth, Metal-Organic Vapor Phase Epitaxy (MOVPE:), MBE (Molecular Beam Epitaxy) or LPE (Liquid Phase Epitaxy) can be used.
(2) Subsequently, the column-like portion 130 is formed (see FIG. 5). In detail, after a photo resist is coated over the semiconductor multi-layered film 150, the photo resist is patterned by the photolithographic method so as to form a predetermined patterned resist layer R100 (FIG. 4). Further, for example, the second mirror 104, the active layer 103 and part of the first mirror 102 are etched by a dry etching method, for example, with the resist layer R100 as a mask to form the column-like semiconductor stacked layer (the column-like portion) 130. Based on the above-mentioned manufacturing process, the resonator 140 including the column-like portion 130 is formed on the substrate 101 as shown in FIG. 5. The resist layer R100 is removed afterwards.
(3) Subsequently current aperture 105 is formed if it is necessary (see FIG. 6). In detail, as shown in FIG. 6, the substrate 101, provided with the resonator 140 formed by the above process, is introduced into a steam atmosphere of around 400 °C, for example, to oxidize the layer with the high Al proportion in the second mirror 104. Hence, the current aperture 105 can be formed. The oxidation rate depends upon the temperature of the furnace, the quantity of steam supply, and the Al proportion and thickness of the layer to be oxidized (the layer of high Al proportion). In the surface-emitting laser provided with the current aperture formed by oxidation, the current flows only in a part where the current aperture is not formed (not oxidized), when this laser is activated. Therefore, in a process of forming the current aperture by oxidation, the current density can be controlled by controlling the range of the current aperture 105 to be formed.
(4) Subsequently the insulation layer 106 surrounding the column-like portion 130 is formed (see FIG. 7).
   Here, a case using a polyimide resin as a material for forming the insulation layer 106 is described. At first, a precursor of a resin (a precursor of a polyimide) is coated over the resonator 140 by a spin coating method, for example, to form a precursor layer of a resin (not shown). In this case, it is formed such that the thickness of the precursor layer is larger than the height of the column-like portion 130. In addition, as a method of forming the precursor layer, conventional technologies such as the above mentioned spin coating method, a dipping method, a spray coating method, and an ink jet method are applicable.
   Subsequently, after this substrate is heated by a hot plate, for example, to remove the solvent, the upper surface 130a of the column-like portion 130 (see FIG. 7) is exposed. As a method of exposing the upper surface 130a of the column-like portion 130, a CMP method, a dry etching method, and a wet etching method can be utilized. Then, the insulation layer 106 is formed by converting the precursor layer to imide in a furnace with 350 °C. Here, the upper surface 130a of the column-like portion 130 may be exposed by etching an insulating layer which is mostly formed during the process of converting the precursor to imide.
(5) Next, the first electrode 107 and the second electrode 109 for injecting current into the active layer 103 and the surface for emitting a laser beam 108 are formed (see FIG. 8).
   At first, the upper surface 130a of the column-like portion 130 is cleaned by a plasma processing method or others, before forming the first electrode 107 and the second electrode 109. Hence, a device having more stable characteristics can be formed. Subsequently, a multi-layered film of such as an alloy of Au and Zn and Au, for example, (not shown) is formed on the insulating layer 106 and the upper surface 130a of the column-like portion 130 (see FIG. 7) by a vacuum evaporation method. In this case, the Au layer is formed on the top surface. Subsequently, a part of the above multi-layered film is removed from the upper surface 130a of the column-like portion 130 by a lift off method. This part becomes the aperture 118 (see FIG. 8). A dry etching method can be used instead of the lift off method.
   The emitting surface 108 is within the aperture 118. In other words, the region of the upper surface 130a of the column-like portion 130 located within the aperture 118 functions as the emitting surface 108.
   In addition, for example, a multi-layered film such as an alloy of Au and Ge and Au (not shown) is formed at the backside 101b of the substrate 101 by a vacuum evaporation method, for example. Subsequently, this film is annealed. The temperature of annealing depends upon the electrode materials. In the case of electrode the materials as used in the present embodiment, it is normally around 400 °C.
(6) Subsequently, the reflectivity adjustment layer 110 is formed on the emitting surface 108 (see FIG. 9 and FIG. 10).

In detail, at first, a resist layer R200 is formed by a photolithographic method within the aperture 118. This resist layer R200 has an aperture 218. This aperture 218 is used to form the reflectivity adjustment layer 110. The aperture 218 has a circular shaped plane whose central axis coincides with the central axis of the aperture 118.

Subsequently, a droplet is charged onto the aperture 218 by an ink jet method to form a precursor 110b (see FIG. 10) of the reflectivity adjustment layer 110 (see FIG. 1 to FIG. 3). Then, this precursor 110b is hardened so as to form the reflectivity adjustment layer 110 on the emitting surface 108b. The precursor 110b is composed of a material which is hardened by an energy beam such as a resin hardened by heat or a resin hardened by ultraviolet light, for example.

As an ejecting method of an ink jet, for example, there are (i) a method of ejecting a liquid under a pressure caused by changing the size of an air bubble in a liquid (a lens material here) with heating and (ii) a method of ejecting a liquid under a pressure caused by a piezoelectric device. Viewed from the aspect of controlling the pressure, the (ii) method is desirable.

Alignment of the position of a nozzle 112 of an ink-jet head 120 with the position for ejecting a droplet 110a is implemented by a conventional image recognition technology used in an exposure process or a test process in general processes for manufacturing a semiconductor integrated circuit. For example, as shown in FIG. 9, alignment of the position of the nozzle 112 of the ink-jet head 120 with the aperture 118 of the surface-emitting laser 100 is implemented by image recognition. After alignment is achieved, the voltage applied to the ink-jet head 120 is controlled. Then, the droplet 110a is discharged. Hence, the precursor 110b is formed on the emitting surface 108 (see FIG. 10).

In this case, there is fluctuation of angles of ejecting the droplet 110a from the nozzle 112 to some degree. However, if the position where the droplet 110a arrives is the inside of the aperture 118, the droplet 110a is spread out in the region surrounded by the resist layer R200 and the position is automatically corrected thereby.

After completing the above process, as shown in FIG. 10, energy beams 113 (ultraviolet rays, for example) are irradiated to harden the precursor 110b. The reflectivity adjustment layer 110 is formed on the emitting surface 108 (see FIG. 1 to FIG. 3). The appropriate amount of irradiation and the wavelength of the ultraviolet ray depend upon the material of the precursor 110b. For example, when the precursor 110b is formed form an acrylic group resin hardened by an ultraviolet light, this precursor is hardened by irradiating an ultraviolet ray of the wavelength of 350nm and at a power of 10mW onto it during five minutes. The resist layer R200 is removed afterwards.

The surface-emitting laser 100 shown in FIG. 1 to FIG. 3 is provided by the above-mentioned processes.

### 4. Functions and advantages

The surface-emitting laser 100 of the present embodiment has the following advantages and functions.
(1) The reflectivity of a region comprising the reflectivity adjustment layer 110 and the part of the second mirror 104 below the reflectivity adjustment layer 110 is smaller than that of the remaining region. In detail, when the wavelength of the laser beam is A, since the second mirror 104 includes a layer whose optical thickness is m₁·λ/2 and the optical thickness of the reflectivity adjustment layer 110 is (2m₂-1)·λ/4, the reflectivity for the laser beam in the first region 191 can be larger than that in the second region 192 (see FIG. 3). Hence, the threshold of laser oscillation in the first region 191 can be decreased compared to that of the second region 192, enabling stable light with transversal mode to be obtained. In particular, a layer whose optical thickness is m₁·λ/2, constitutes the top layer of the second mirror 104, enabling the reflectivity in the first region 191 to be increased efficiently and stable light with transversal mode to be obtained surely.
(2) At least one part of the first electrode 107 is formed on the upper surface 130a of the resonator 130, the aperture 118 is formed on the upper surface 130a of the resonator 130 and the reflectivity adjustment layer 110 is formed on the emitting surface 108 within this aperture 118. In other words, since the layer for the first electrode 107 differs from the reflectivity adjustment layer 110, the configuration and the size of the first electrode 107 can be formed independently from that of the reflectivity adjustment layer 110, enabling a device design to be versatile.
(3) The reflectivity adjustment layer 110 is composed of a resin hardened by heat or a resin hardened by ultraviolet light. In addition, this reflectivity adjustment layer 110 can be formed by an ink-jet method.

The reflectivity adjustment layer 110 is formed by an ink-jet method such that damage applied to the device to be formed can be reduced compared with forming the reflectivity adjustment layer 110 by the CVD method, evaporation and etching, and the reflectivity adjustment layer 110 can be easily formed. In addition, when forming the reflectivity adjustment layer 110 by an ink-jet method, the amount of droplets is adjusted so as to control the thickness of the reflectivity adjustment layer 110 easily with high precision.

### Second Embodiment

### 1. Structure of the surface emitting semiconductor laser

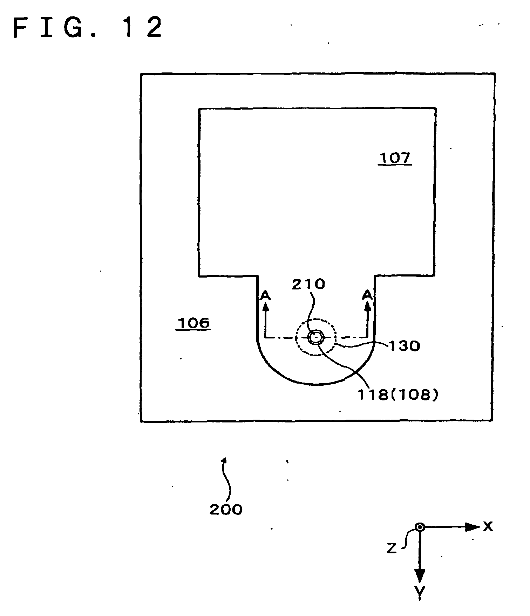

Fig. 11 shows a schematic sectional view of the surface-emitting laser 200 of a second embodiment to which the present invention is applied. Fig. 12 shows a schematic plan view of this surface-emitting laser 200. FIG.11 is a section along the A-A line of FIG. 12.

The surface-emitting laser 200 of this embodiment has mostly the same structure as the surface-emitting laser 100 of the first embodiment except that an reflectivity adjustment layer 210 is formed in the entire aperture 118 of the first electrode 107. The same reference numbers refer to structural elements having substantially the same function as in the first embodiment and their detailed description is not repeated.

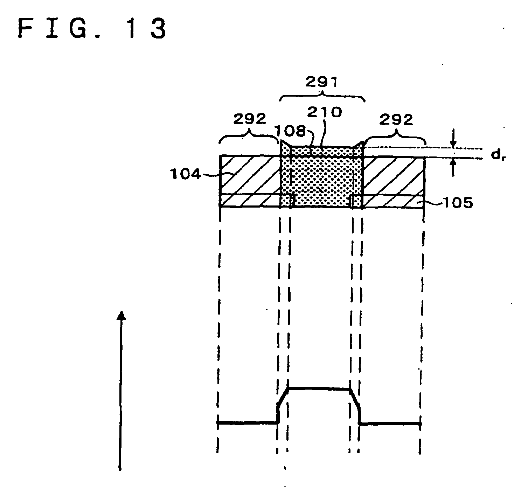

FIG. 11 shows a sectional profile of reflectivity of the second mirror 104 along with the surface-emitting laser 200. In addition, FIG. 13 shows an expanded sectional view of the neighborhood of the second mirror 104 in FIG. 11. As shown in FIG. 13, a region comprising the reflectivity adjustment layer 210 and the portion of the second mirror 104 below the reflectivity adjustment layer 210 is defined as a first region 291 and the remaining region is defined as the second region 292. In detail, in FIG. 13, a dotted region is the first region 291, and a hatched region is the second region 292.

In this surface-emitting laser 200, the reflectivity for a laser beam in the first region 291 is larger than the reflectivity for a laser beam in the second region 292 like this is the case with the surface-emitting laser 100 of the first embodiment. Hence, the first region 291 generates laser oscillation more efficiently compared with the second region 292 so as to obtain single-mode light more efficiently.

For example, in the reflectivity adjustment layer 210, the optical thickness "d,"(see FIG. 13) in the portion except the neighborhood of the first electrode 107 can be (2m ₂-1)·λ/4 (m₂, natural number) like that of the reflectivity adjustment layer 110. In addition, this reflectivity adjustment layer 210 is composed of the same material as the reflectivity adjustment layer 110 of the first embodiment.

Furthermore, as shown in FIG. 11 and FIG. 13, the thickness of the reflectivity adjustment layer 210 is not a constant, but can be increased around the neighborhood of a contact surface with the first electrode 107 instead. Hence, the reflectivity of the first region 291 is lowered (see FIG. 13) as it approaches the contact surface in the neighborhood of a contact surface with the first electrode 107.

### 2. A manufacturing process of a surface emitting semiconductor laser

The surface-emitting laser 200 of the second embodiment can be formed using the same manufacturing process as that used for the surface-emitting laser 100 up to the process for forming the electrodes 107 and 109 inclusive. Hence, the description of processes that are common to both embodiments is omitted.

After forming the above electrodes, in the first embodiment, a resist layer R200 was formed at the aperture 118 in the process of forming reflectivity adjustment layer 110 and a droplet 110a was ejected onto the aperture 218 formed in the resist layer R200 (see FIG.9). On the other hand, in this embodiment, in the process of forming reflectivity adjustment layer 210, a droplet 110a is directly ejected within the aperture 118 (see FIG. 9) without forming the resist layer R200 so as to form a precursor (not shown) of the reflectivity adjustment layer. The manufacturing process thereafter (the hardening process) is the same as that of the first embodiment. Hence, the reflectivity adjustment layer 210 (see FIG. 11 to FIG. 13) is formed thereby.

In addition, before ejecting the droplet 110a in the aperture 118, a process of enhancing the wettability with the droplet 110a can be implemented to the side of the emitting surface 108 and the aperture 118, if it is necessary.

### 3. Operations, functions and effects of the surface emitting semiconductor laser

The operation of the surface-emitting laser 200 of the present embodiment is basically the same of that of the surface-emitting laser 100 of the first embodiment and detailed description of it is omitted.

In addition, the surface-emitting laser 200 of the present embodiment and a method of manufacturing it have substantially the same functions and effects as the surface-emitting laser 100 of the first embodiment.

Furthermore, in the surface-emitting laser 200 of the present embodiment, the reflectivity adjustment layer 210 can be formed by ejecting the droplet 110a directly into the aperture 118. Hence, this reflectivity adjustment layer 210 can be formed without using the resist layer R200. Thus, the region having high reflectivity can be necessarily limited by a simple method, enabling a surface-emitting laser to control a stabilized transversal mode.

### Third Embodiment

### 1. Structure of the surface emitting semiconductor laser

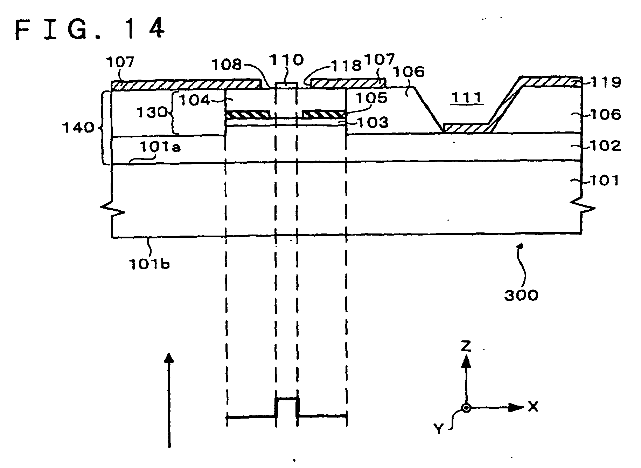

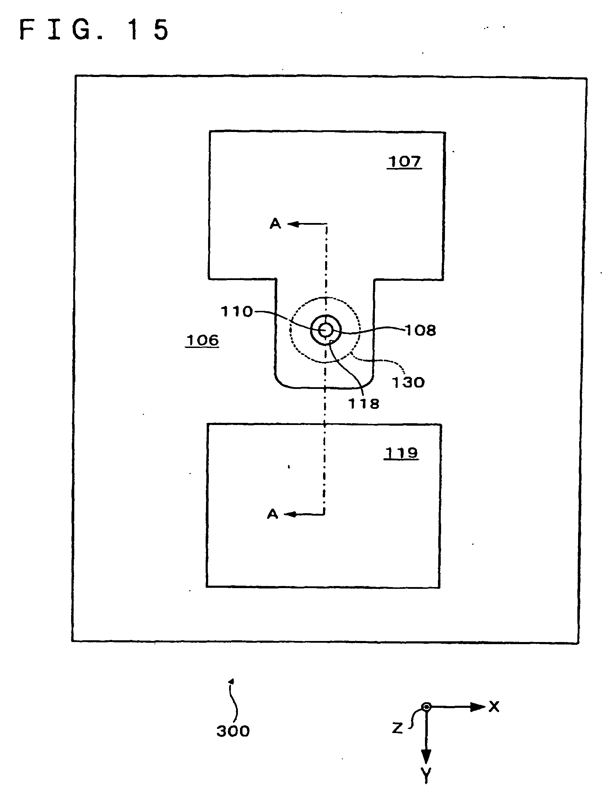

Fig. 14 shows a schematic sectional view of a surface-emitting laser 300 of a third embodiment to which the present invention is applied. Fig. 15 shows a schematic plan view of this surface-emitting laser 300. FIG.14 is section along the A-A line in FIG. 15.

The surface-emitting laser 300 of the present embodiment has the same constitution as the surface-emitting laser 100 of the first embodiment except that the second electrode 119 is formed on the surface 101a of the substrate 101 like the first electrode 107. The same reference numerals refer to constituents having substantially the same function as those of the surface emission laser 100 of the first embodiment and the detailed description of them is omitted.

In this surface-emitting laser 300, two pads of the first electrode 107 and the second electrode 119, respectively, are formed on the upper surface 101a of the substrate 101. As shown in FIG. 14, an aperture 111 is formed to reach the first mirror 102 at least.

### 2. Process for manufacturing the surface emitting semiconductor laser

The surface-emitting laser 300 of the present embodiment is manufactured by a process basically the same as that for the surface-emitting laser 100 of the first embodiment. In other words, in the process like that for manufacturing the surface-emitting laser 100 of the first embodiment described above, after the insulating layer 106 is formed on the resonator 140 (see. FIG. 7), the aperture 111 is formed in the insulating layer 106 (see FIG. 14). As a method of forming the aperture 111, a wet etching method or a dry etching method can be exemplified. The exposed surface of the first mirror 102 corresponding to the bottom surface of the aperture 111 may be etched, if it is necessary.

Subsequently, the first electrode 107 is formed as in the first embodiment. Furthermore, the second electrode 119 is formed from the bottom surface of the aperture 111 to an upper surface of the insulation layer 106. The second electrode 119 can be composed of the same material as that used for forming the second electrode 109 of the surface-emitting laser 100 of the first embodiment. In addition, in this embodiment, when forming the second electrode 119, by using a lift off method, for example, an area from the exposed surface of the first mirror 102 corresponding to the bottom surface of the aperture 111 to the upper surface of the insulating layer 106 is patterned. The process thereafter (the process for forming the reflectivity adjustment layer 110) is similar to that of the first embodiment. Hence, the surface-emitting laser 300 can be formed by the above processes.

### 3. Operations, functions and effects of the surface emitting semiconductor laser

The operation of the surface-emitting laser 300 is basically the same as that of the surface-emitting laser 100 of the first embodiment and its explanation is omitted.

Furthermore, with the surface-emitting laser 300 of the present embodiment, both the first electrode 107 and second electrode 119 are formed on the surface 101 a of the substrate 101.

Hence, drive elements, for example, can be mounted above the first electrode 107 and the second electrode 119, via a bump. Hence, a device that can be driven without wiring and is adapted to be mounted as a face-down structure can be attained. In addition, because the first electrode 107 and the second electrode 119 are formed on the same surface, a plurality of pads is formed on the same surface, enabling stabilized mounting to be attained.

### Fourth Embodiment

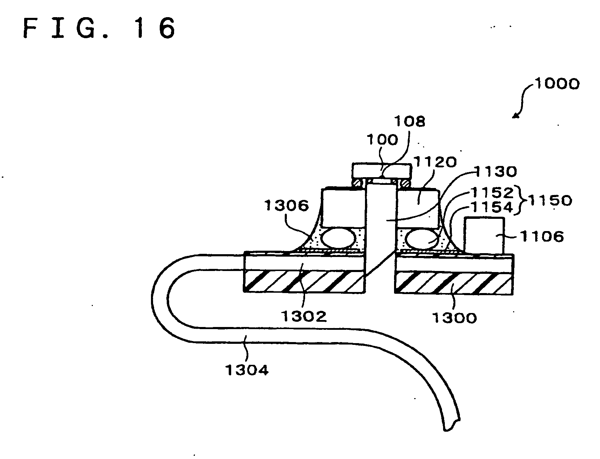

Fig. 16 shows a schematic view of a light module according to a fourth embodiment of the present invention. The light module includes a structural body 1000 (see FIG. 16). This structural body 1000 comprises the surface-emitting laser 100 of the first embodiment (see FIG. 1), a platform 1120, a first optical wave-guide 1130 and an actuator 1150. In addition, this structural body 1000 includes a second optical wave-guide 1302. The second optical wave-guide 1302 is a part of the substrate 1308. An optical wave-guide 1304 for connection may be optically connected to the second optical wave-guide1302.

The optical wave-guide 1304 for connection may be an optical fiber. In addition, platform 1120 is fixed to the substrate 1308 by a resin 1306.

With the light module of this embodiment, after emitting light from the surface-emitting laser 100 (the emitting surface 108 see FIG. 1), this light is received by a light receiving element (not shown) via the first and the second optical wave-guide 1130 and 1302 (and an optical wave-guide 1304 for connection).

### Fifth Embodiment

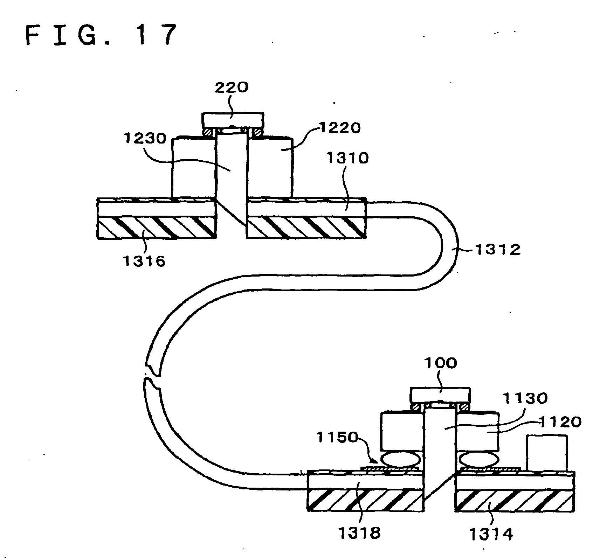

Fig. 17 shows a light transmission device according to a fifth embodiment of the present invention. In this embodiment, a plurality of third optical wave-guides 1230, 1310, and 1312 are provided between the first optical wave-guide 1130 and a light-receiving element 220. In addition, the light transmission device includes a plurality (two) of substrates 1314 and 1316.

In this embodiment, the third optical wave-guide 1312 is provided between the side of the surface-emitting laser 100 (including the surface-emitting laser 100, the platform 1120, the first optical wave-guide 1130, the second optical wave-guide 1318 and the actuator 1150) and the side of the light receiving element 220 (including a light receiving element 220, the plat form 1220 and the third optical wave-guides 1230 and 1310). As the third optical wave-guide 1312, an optical fiber is employed so as to transmit light among plural electronic devices.

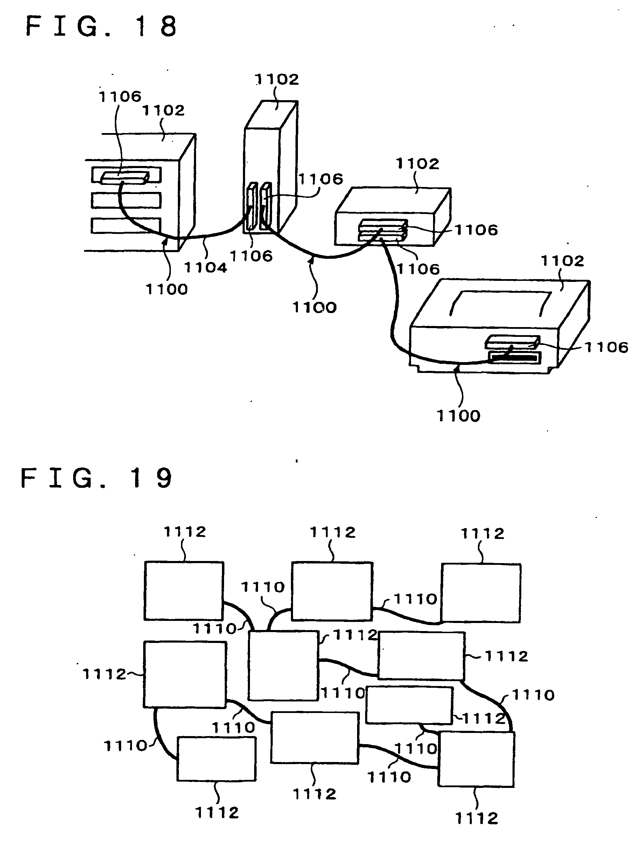

For example, in FIG. 18, electronic devices 1102 such as a computer, a display, a storage device, and a printer are mutually connected by light transmission devices 1100. Electronic devices 1102 may be information communication devices. A light transmission device 1100 comprises a cable 1104 including the third optical wave-guide 1312 such as an optical fiber. In the light transmission device 1100, a plug 1106 may be installed at the both ends of the cable 1104. In each of the plugs 1106, the surface-emitting laser 100 and the light receiving element 220 sides are installed. An electrical signal output from any of electronic devices 1102 is converted to an optical signal by an emitting device so as to be transmitted via the cable 1104 and converted to an electrical signal by the receiving element. An electrical signal is input into the other electronic device 1102. Thus, with the light transmission devices 1100 of this embodiment, information among electronic devices 1102 can be conveyed by optical signals.

FIG.19 shows a usage of the light transmission device of this embodiment. Electronic devices 1112 are connected to each other by the light transmission devices 1110. As electronic devices 1112, a liquid crystal display monitor and a CRT for digital display (can be used in the field of finance, mail order, medical care, and education), a liquid crystal projector, a plasma display panel (PDP), a digital TV, a cash register of a retail store (for POS (Point of Sale Scanning) business), a video, a tuner, a game device, and a printer are cited.

In addition, in a light transmission device shown in FIG. 18 and FIG. 19, even when the surface-emitting laser 200 (see FIG. 11 to FIG. 13) or the surface-emitting laser 300 is used instead of the surface-emitting laser 100 the same functions and effects can be attained.

### Sixth Embodiment

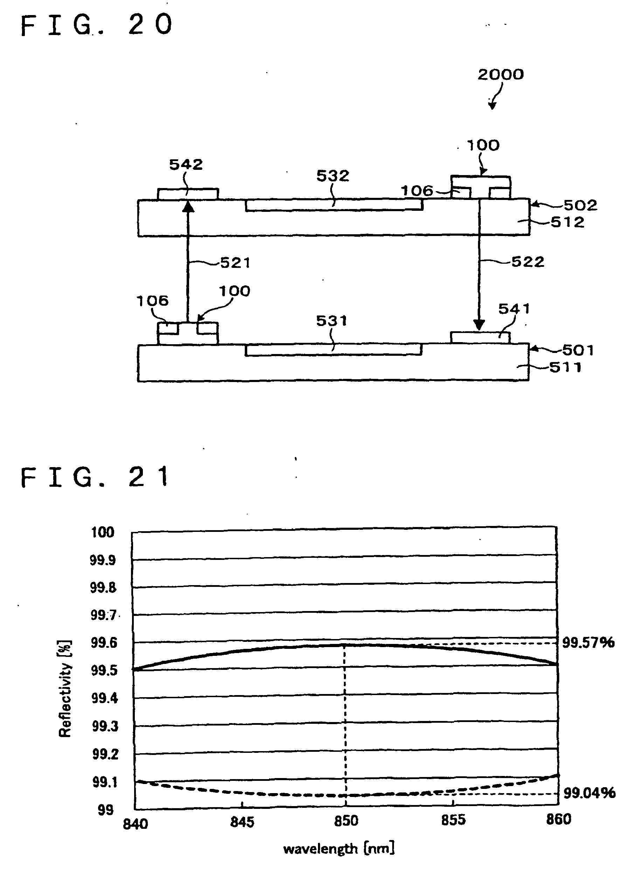

Fig. 20 shows a drawing explaining a light transmission device according to a sixth embodiment of the present invention. In this embodiment, an example where a light transmission device is a light interconnection device 2000 between IC chips is described.

### 1. Structure of the light transmission device

The light interconnection device 2000 of the present embodiment is provided with a plurality of stacked IC chips. In the light interconnection device 2000 of the present embodiment, as shown in FIG. 20, two IC chips are stacked. But, the number of stacked IC chips is not limited to two.

In the light interconnection device 2000 of the present embodiment, laser beams 521, 522 are transmitted between the stacked IC chips 501, and 502 to exchange data. IC chips 501 and 502 include substrates (for example, a silicon substrate) 511 and 512 and IC regions 531 and 532 formed on the substrates 511 and 512, respectively. A CPU, a memory, and an ASIC are exemplified as IC chips 501 and 502.

In the IC chip 501, the surface-emitting laser 100 of the first embodiment and a light detection device 541 are installed on the substrate 511. Similarly, in the IC chip 502, the surface-emitting laser 100 of the first embodiment and a light detection device 542 are installed on the substrate 512. Although this embodiment uses the surface-emitting laser 100 of the first embodiment both on the substrates 511 and the substrate 512, one of or both of these surface-emitting lasers 100 can be replaced by the second or the third surface-emitting laser 200 and 300.

### 2. Operation of the light transmission device

Next, operation of this light interconnection device 2000 is described referring to Fig. 20.

In this light interconnection device 2000, a signal electrically processed in the IC region 531 of the IC chip 501 is converted to a laser pulse signal by the resonator 140 (see FIG.1 not shown in FIG.20) of the surface-emitting laser 100 and then transmitted to the light detection device 542 of the IC chip 502. The light detection device 542 converts a received laser pulse to an electrical signal, and transmits it to the IC region 532.

On the other hand, the same operation is implemented in case when a laser from the surface-emitting laser 100 formed on the IC chip 502 is transmitted to the light detection device 541. In other words, in the light interconnection device 2000, a signal electrically processed in the IC region 532 of the IC chip 502 is converted to a laser pulse signal by the resonator 140 of the surface-emitting laser 100 and then transmitted to the light detection device 541 of the IC chip 501. The light detection device 541 converts a received laser pulse to an electrical signal, and transmits it to the IC region 531. Hence, data are exchanged between IC chips 501, 502 via a laser.

In addition, when the substrates 511 and 512 are composed of silicon, the wavelength of a laser oscillation in the resonator of the surface-emitting laser 100 is set to be over 1.1 µm, enabling the light emitted from the surface-emitting laser 100 to transit through the substrates 511 and 512 (silicon substrates).

By the way, generally, the following problems exist in signal transmission between IC chips via an electrical connection accompanied with high frequency and high speed of signal processing.
- A shift (skew) of the signal transmission timing between wiring occurs.
- Power consumption in transmitting a high frequency electrical signal is increased.
- The design of wiring layout becomes difficult.
- An impedance matching is necessary
- An interception measure against ground noise is necessary

On the other hand, these problems can be solved by transmitting signals among IC chips as light signals such as with the light interconnection device 2000 of the present embodiment.

The present invention is not limited to the above-mentioned embodiments, but various modifications may be applied. For example, the present invention includes a constitution which is substantially the same constitution explained in the embodiments (constitution, for example, having the same function, the same method and the same result or the same objective and result). In addition, the present invention includes a constitution that non-essential parts of constitution explained in the embodiment are replaced with others. In addition, the present invention includes a constitution that can achieve the same functions and effects shown in the constitution explained in the above embodiments or the same objective thereof. In addition, the present invention includes a constitution that publicly known technology is added to the constitution explained in the above-mentioned embodiments.

For example, in the above embodiment, a surface emitting semiconductor laser including a single column-like portion was explained. But, the scope of the present invention encompasses a plurality of column-like portions on one substrate. In addition, a case when a plurality of surface emitting semiconductor lasers is arranged in an array has the same functions and effects.

In addition, for example, in accordance with the present invention the p-type may be replaced with n-type in each of semiconductor layers. In the above-mentioned embodiments, a material of AlGaAs group was employed. But other materials, for example, such as a GalnP group, a ZnSSe group, an InGaN group, an AlGaN group, an InGaAs group, a GalnAs group and GaAsSb group can be employed depending on a wavelength of a laser oscillation.

Furthermore, in the above-mentioned embodiment, a GaAs substrate was shown as a compound semiconductor substrate. But, other compound semiconductor substrates, for example, such as a GaN substrate, an AIN substrate, an InP substrate, a GaP substrate, a ZnSe substrate, a ZnS substrate, a CdTe substrate, a ZnTe substrate, and a CdS substrate can be employed.

### Experimental example

With respect to the surface-emitting laser 100 of the first embodiment, a simulation test of the reflectivity of the second mirror 104 was implemented. Fig. 21 shows the reflectivity of the first and second regions 191 and 192 of the second mirror 104 provided by this measurement.

In addition, in this measurement, each of layers composing the surface-emitting laser 100 has the same constitution and composition as shown in the above-mentioned embodiment. The wavelength of the oscillation in the surface-emitting laser 100 is 850nm. In addition, in this measurement, reflectivity shown by the example does not include the reflectivity of the current aperture 105.

At first, when the second mirror 104 comprises a multi-layer film including 25 pairs an n-type Al_{0.9}Ga_{0.1}As layer and an n-type Al_{0.15}Ga_{0.85}As each, the layers are deposited alternately and their optical thickness is λ/4 each, but that of the top layer is λ/2, the reflectivity of the second mirror 104 was 99.04% for light of the oscillation wavelength of 850nm. In this case, when the reflectivity adjustment layer 110 whose optical thickness was λ/4, was formed on the emitting surface 108 in addition to the top layer whose optical thickness was λ/2, the reflectivity of the first region 191 (see FIG.3) of the second mirror 104 was 99.57% and the reflectivity of the second region 192 (see FIG. 3) was 99.04%, i.e., the same as in the case without the reflectivity adjustment layer 110. In addition, FIG. 21 shows the reflectivity for each wavelength in the first region 191 and the second region 192, respectively. In Fig. 21, a solid line shows the reflectivity of the first region 191 and a broken line shows the reflectivity of the second region 192.

According to the experimental example, the optical thickness of the top layer of the second mirror 104 was λ/2 and the reflectivity adjustment layer 110 whose optical thickness was λ/4, was formed on the emitting surface 108, enabling the reflectivity for a laser in the first region 191 to be larger than that in the second region 192 (see FIG.21). Thus, the threshold value of the laser oscillation in the first region 191 can be reduced compared with that in the second region 192, enabling a laser to have a stabilized transversal mode.

## Claims

1. A surface emitting semiconductor laser including a resonator (140) formed on a substrate (101) and emitting a laser beam in a direction perpendicular to the substrate (101) from an emitting surface (10B) formed on the upper surface of the resonator (140), wherein
the resonator (140) includes on the substrate (101) a first mirror (102), an active layer (103) and a second mirror (104) comprising the emitting surface (108) as part of its upper surface, the first mirror (102) and the second mirror (104) sandwiching the active layer (103); and
the second mirror (104) includes a layer whose optical thickness is m₁·λ/2, wherein m₁ is a natural number equal to or larger than 1 and λ is the wavelength of the laser beam:
**characterized in that** a reflectivity adjustment layer (110) is formed on that part of the emitting surface (108), where the light is emitted;
the optical thickness of the reflectivity adjustment layer (110) is (2m₂-1)·λ/4, wherein m₂ is a natural number equal to or larger than 1.

2. The laser of claim 1, wherein the reflectivity for the laser beam in a first region is larger than that in a second region, the first region being defined as a region comprising the reflectivity adjustment layer (110) and the region of the second mirror (104) below the reflectivity adjustment layer (110), and the second region being defined as the remaining region of the second mirror (104).

3. The laser of claim 1, further comprising:
a first electrode (107) and a second electrode (109) for injecting electric current into the resonator (140), wherein
at least part of the first electrode (107) is formed on the upper surface of the resonator (140),
an aperture (118) is formed in the first electrode (107) on the upper surface of the resonator (140), and
the emitting surface (108) is provided within the aperture.

4. The laser of claim 3, wherein the resonator (140) includes on the substrate (101) a first mirror (102) formed on the substrate, an active layer (103) and a second mirror (104), the first mirror (102) and the second mirror (104) sandwiching the active layer (103); and
the reflectivity for the laser beam in a first region is larger than that in a second region, the first region being defined as a region comprising the reflectivity adjustment layer (110) and the region of the second mirror (104) below the reflectivity adjustment layer (110), and the second region being defined as the remaining region of the second mirror (104).

5. The laser of any one of claims 1 to 4, wherein the layer whose optical thickness is m₁·λ/2 constitutes the top layer of the second mirror (104).

6. The laser of any one of claims 1, 2, 4 and 5, wherein the reflectivity adjustment layer (110) is transparent to the laser beam.

7. The laser of any one of claims 1, 2 and 4 to 6, wherein the plane configuration of the reflectivity adjustment layer (110) is circular.

8. The laser of claim 7, wherein the diameter of the reflectivity adjustment layer (110) is equal to or less than 6 µm.

9. The laser of claim 7, wherein the emitting surface (108) is circular and the reflectivity adjustment layer (110) is arranged coaxially with the center axis of the emitting surface (108).

10. The laser of claim 1 or 3, wherein the reflectivity adjustment layer (110) is composed of a resin hardened by heat or a resin hardened by ultraviolet light.

11. The laser of claim 3, wherein the thickness of the reflectivity adjustment layer (110) is uneven.

12. The laser of claim 11, wherein the thickness of the reflectivity adjustment layer (210) in an area close to the contact surface with the first electrode (107) is larger than that of the other area.

13. The laser of claim 1 or 4, wherein the second mirror (104) is provided with a current aperture (105) having a concentric circular ring-shaped plane, and the area of the inner circle of the current aperture (105) is larger than the sectional area of the reflectivity adjustment layer (110).

14. The laser of any one of claims 1 to 13, wherein at least one part of the resonator (140) includes a column-like portion (130).

15. A light module comprising an optical wave-guide (1130, 1302) and the surface emitting semiconductor laser claimed in any one of claims 1 to 14.

16. A light transmission device comprising a light module according to claim 15.

17. A method of manufacturing a surface emitting semiconductor laser including a resonator (140) formed on a substrate (101) and emitting a laser beam in a direction perpendicular to the substrate (101) from an emitting surface (108) formed on the upper surface of the resonator (140), comprising: and
(a) forming a resonator (140) on the substrate (101) by forming a first mirror (102), an active layer (103) and a second mirror (104) comprising the emitting surface (108) as part of its upper surface, so that the first mirror (102) and the second mirror (104) sandwich the active layer (103), wherein the second mirror (104) is formed to include a layer with an optical thickness of m₁·λ/2, m₁ being a natural number equal to or larger than 1 and λ the wavelength of the laser beam;
**characterized by**
(b) forming a reflectivity adjustment layer (110) with an optical thickness of (2m₂-1)·λ/4. wherein m₂ is a natural number equal to or larger than 1, on that part of the emitting surface (108), where the light is emitted.

18. The method of claim 17, wherein the step (b) comprises forming a precursor of the reflectivity adjustment layer (110) by ejecting a droplet onto the emitting surface (108), and hardening the precursor thereafter to form the reflectivity adjustment layer (110).

19. The method of claim 17 or 18, further comprising:
(c) forming a first electrode (107) and a second electrode (109) to inject a current into the resonator (140), wherein at least part of the first electrode (107) is formed on the upper surface of the resonator (140) and an aperture is formed in on the upper surface of the resonator (140),
wherein step (c) comprises forming said reflectivity adjustment layer (110) on the emitting surface (108).

## Patentansprüche

1. Oberflächenemittierender Halbleiterlaser, der einen auf einem Substrat (101) ausgebildeten Resonator (140) beinhaltet und einen Laserstrahl in einer Richtung senkrecht zum Substrat (101) von einer Abstrahlfläche (108) emittiert, die auf der Oberseite des Resonators (140) ausgebildet ist, wobei
der Resonator (140) auf dem Substrat (101) einen ersten Spiegel (102), eine aktive Schicht (103) und einen zweiten Spiegel (104) beinhaltet, der die Abstrahlfläche (108) als Teil seiner Oberseite beinhaltet, wobei der erste Spiegel (102) und der zweite Spiegel (104) die aktive Schicht (103) sandwichartig einschließen; und
der zweite Spiegel (104) eine Schicht beinhaltet, deren optische Dicke m₁·λ/2 beträgt, wobei m₁ eine natürliche Zahl gleich oder größer 1 ist und λ die Wellenlänge des Laserstrahls ist;
**dadurch gekennzeichnet, dass** eine Schicht (110) zur Anpassung des Reflexionsvermögens auf demjenigen Teil der Abstrahlfläche (108) ausgebildet ist, von dem das Licht emittiert wird; und
die optische Dicke der Schicht (110) zur Anpassung des Reflexionsvermögens (2m₂ - 1)·λ/4 beträgt, wobei m₂ eine natürliche Zahl gleich oder größer 1 ist.

2. Laser nach Anspruch 1, bei dem das Reflexionsvermögen für den Laserstrahl in einem ersten Gebiet größer als dasjenige in einem zweiten Gebiet ist, wobei das erste Gebiet als ein Gebiet definiert ist, das die Schicht (110) zur Anpassung des Reflexionsvermögens und das Gebiet des zweiten Spiegels (104) unterhalb der Schicht (110) zur Anpassung des Reflexionsvermögens beinhaltet, und das zweite Gebiet als das restliche Gebiet des zweiten Spiegels (104) definiert ist.

3. Laser nach Anspruch 1, welcher weiter aufweist:
eine erste Elektrode (107) und eine zweite Elektrode (109) zum Injizieren eines elektrischen Stroms in den Resonator (140), wobei
zumindest ein Teil der ersten Elektrode (107) auf der Oberseite des Resonators (140) ausgebildet ist,
eine Apertur (118) in der ersten Elektrode (107) auf der Oberseite des Resonators (140) ausgebildet ist, und
die Abstrahlfläche (108) innerhalb der Apertur vorgesehen ist.

4. Laser nach Anspruch 3, bei dem der Resonator (140) auf dem Substrat (101) einen ersten Spiegel (102), der auf dem Substrat ausgebildet ist, eine aktive Schicht (103) und einen zweiten Spiegel (104) beinhaltet, wobei der erste Spiegel (102) und der zweite Spiegel (104) die aktive Schicht (103) sandwichartig einschließen; und
das Reflexionsvermögen für den Laserstrahl in einem ersten Gebiet größer als dasjenige in einem zweiten Gebiet ist, wobei das erste Gebiet als ein Gebiet definiert ist, das die Schicht (110) zur Anpassung des Reflexionsvermögens und das Gebiet des zweiten Spiegels (104) unterhalb der Schicht (110) zur Anpassung des Reflexionsvermögens beinhaltet, und das zweite Gebiet als das restliche Gebiet des zweiten Spiegels (104) definiert ist.

5. Laser nach einem der Ansprüche 1 bis 4, bei dem die Schicht, deren optische Dicke m₁·λ/2 ist, die obere Schicht des zweiten Spiegels (104) bildet.

6. Laser nach einem der Ansprüche 1, 2, 4 und 5, bei dem die Schicht (110) zur Anpassung des Reflexionsvermögens für den Laserstrahl durchlässig ist.

7. Laser nach einem der Ansprüche 1, 2, und 4 bis 6, bei dem die Konfiguration der Schicht (110) zur Anpassung des Reflexionsvermögens in der Draufsicht kreisförmig ist.

8. Laser nach Anspruch 7, bei dem der Durchmesser der Schicht (110) zur Anpassung des Reflexionsvermögens 6 µm oder weniger beträgt.

9. Laser nach Anspruch 7, bei dem die Abstrahlfläche (108) kreisförmig ist und die Schicht (110) zur Anpassung des Reflexionsvermögens koaxial zur Mittelachse der Abstrahlfläche (108) angeordnet ist.

10. Laser nach Anspruch 1 oder 3, bei dem die Schicht (110) zur Anpassung des Reflexionsvermögens aus einem durch Wärme oder einem durch ultraviolettes Licht gehärteten Harz besteht.

11. Laser nach Anspruch 3, bei dem die Dicke der Schicht (110) zur Anpassung des Reflexionsvermögens ungleichmäßig ist.

12. Laser nach Anspruch 11, bei dem die Dicke der Schicht (210) zur Anpassung des Reflexionsvermögens in einem Gebiet in der Nähe der Kontaktfläche zur ersten Elektrode (107) größer als die des übrigen Gebietes ist.

13. Laser nach Anspruch 1 oder 4, bei dem der zweite Spiegel (104) mit einer Stromapertur (105) versehen ist, die eine konzentrische kreisringförmige Ebene aufweist, und der Flächeninhalt des inneren Kreises der Stromapertur (105) größer als die Querschnittsfläche der Schicht (110) zur Anpassung des Reflexionsvermögens ist.

14. Laser nach einem der Ansprüche 1 bis 13, bei dem mindestens ein Teil des Resonators (140) einen säulenartigen Abschnitt (130) beinhaltet.

15. Lichtmodul, das einen optischen Wellenleiter (1130, 1302) und den oberflächenemittierenden Halbleiterlaser nach einem der Ansprüche 1 bis 14 aufweist.

16. Lichtübertragungsvorrichtung, die ein Lichtmodul nach Anspruch 15 aufweist.

17. Verfahren zur Fertigung eines oberflächenemittierenden Halbleiterlasers, der einen auf einem Substrat (101) ausgebildeten Resonator (140) beinhaltet und einen Laserstrahl in einer Richtung senkrecht zum Substrat (101) von einer Abstrahlfläche (108) emittiert, die auf der Oberseite des Resonators (140) ausgebildet ist, wobei das Verfahren beinhaltet:
(a) Ausbilden eines Resonators (140) auf dem Substrat (101) durch Ausbilden eines ersten Spiegels (102), einer aktiven Schicht (103) und eines zweiten Spiegels (104), der die Abstrahlfläche (108) als Teil seiner Oberseite aufweist, so dass der erste Spiegel (102) und der zweite Spiegel (104) die aktive Schicht (103) sandwichartig einschließen, wobei der zweite Spiegel (104) so ausgebildet wird, dass er eine Schicht mit einer optischen Dicke von m₁·λ/2 zu beinhaltet, wobei m₁ eine natürliche Zahl gleich oder größer 1 ist und λ die Wellenlänge des Laserstrahls ist;
**gekennzeichnet durch**
(b) Ausbilden einer Schicht (110) zur Anpassung des Reflexionsvermögens mit einer optischen Dicke von (2m₂ - 1)·λ/4, wobei m₂ eine natürliche Zahl gleich oder größer 1 ist, und zwar auf dem Teil der Abstrahlfläche (108), von dem das Licht emittiert wird.

18. Verfahren nach Anspruch 17, bei dem der Schritt (b) beinhaltet, dass ein Vorläufer der Schicht (110) zur Anpassung des Reflexionsvermögens durch Ausstoßen eines Tröpfchens auf die Abstrahlfläche (108) und nachfolgendes Härten des Vorläufers ausgebildet wird, um die Schicht (110) zur Anpassung des Reflexionsvermögens zu erzeugen.

19. Verfahren nach Anspruch 17 oder 18, das weiter beinhaltet:
(c) Ausbilden einer ersten Elektrode (107) und einer zweiten Elektrode (109), um einen Strom in den Resonator (140) zu injizieren, wobei zumindest ein Teil der ersten Elektrode (107) auf der Oberseite des Resonators (140) ausgebildet wird und eine Apertur auf der Oberseite des Resonators (140) ausgebildet wird,
wobei Schritt (c) beinhaltet, dass die Schicht (110) zur Anpassung des Reflexionsvermögens auf der Abstrahlfläche (108) ausgebildet wird.

## Revendications

1. Laser à semi-conducteurs à émission de surface comprenant un résonateur (140) formé sur un substrat (101) et émettant un faisceau laser dans une direction perpendiculaire au substrat (101) à partir d'une surface (108) émettrice formée sur la surface supérieure du résonateur (140), dans lequel
le résonateur (140) comprend sur le substrat (101) un premier miroir (102), une couche (103) active et un deuxième miroir (104) comprenant la surface (108) émettrice comme partie de sa surface supérieure, le premier miroir (102) et le deuxième miroir (104) prenant en sandwich la couche (103) active ; et
le deuxième miroir (104) comprend une couche dont l'épaisseur optique est m₁·λ/2, m₁ étant un nombre naturel supérieur ou égal à 1 et λ étant la longueur d'onde du faisceau laser ;
**caractérisé en ce qu'**une couche (110) de réglage du facteur de réflexion est formée sur la partie de la surface (108) émettrice où la lumière est émise ;
l'épaisseur optique de la couche (110) de réglage du facteur de réflexion est (2m₂-1)•λ/4, m₂ étant un nombre naturel supérieur ou égal à 1.

2. Laser suivant la revendication 1, dans lequel le facteur de réflexion du faisceau laser dans une première région est plus grand que dans une deuxième région, la première région étant définie comme étant une région comprenant la couche (110) de réglage du facteur de réflexion et la région du deuxième miroir (104) en dessous de la couche (110) de réglage du facteur de réflexion, et la deuxième région étant définie comme la région restante du deuxième miroir (104).

3. Laser suivant la revendication 1 comprenant en outre :
une première électrode (107) et une deuxième électrode (109) pour injecter du courant électrique dans le résonateur (140), dans lequel
au moins une partie de la première électrode (107) est formée sur la surface supérieure du résonateur (140),
une ouverture (118) est formée dans la première électrode (107) sur la surface supérieure du résonateur (140), et
la surface (108) émettrice est ménagée dans l'ouverture.

4. Laser suivant la revendication 3, dans lequel le résonateur (140) comprend sur le substrat (101) un premier miroir (102) formé sur le substrat, une couche (103) active et un deuxième miroir (104), le premier miroir (102) et le deuxième miroir (104) prenant en sandwich la couche (103) active ; et
le facteur de réflexion du faisceau laser dans une première région est plus grand que celui dans une deuxième région, la première région étant définie comme une région comprenant la couche (110) de réglage du facteur de réflexion et la région du deuxième miroir (104) en dessous de la couche (110) de réglage du facteur de réflexion, et la deuxième région étant définie comme étant la région restante du deuxième miroir (104).

5. Laser suivant l'une quelconque des revendications 1 à 4, dans lequel la couche dont l'épaisseur optique est m₁•λ/2 constitue la couche supérieure du deuxième miroir (104).

6. Laser suivant l'une quelconque des revendications 1, 2, 4 et 5, dans lequel la couche (110) de réglage du facteur de réflexion est transparente au faisceau laser.

7. Laser suivant l'une quelconque des revendications 1, 2 et 4 à 6, dans lequel la configuration plane de la couche (110) de réglage du facteur de réflexion est circulaire.

8. Laser suivant la revendication 7, dans lequel le diamètre de la couche (110) de réglage du facteur de réflexion est inférieur ou égal à 6 µm.

9. Laser suivant la revendication 7, dans lequel la surface (108) émettrice est circulaire et la couche (110) de réglage du facteur de réflexion est disposée coaxialement à l'axe passant par le centre de la surface (108) émettrice.

10. Laser suivant la revendication 1 ou 3, dans lequel la couche (110) de réglage du facteur de réflexion est composée d'une résine durcie par la chaleur ou d'une résine durcie par de la lumière ultraviolette.

11. Laser suivant la revendication 3, dans lequel l'épaisseur de la couche (110) de réglage du facteur de réflexion est inégale.

12. Laser suivant la revendication 11, dans lequel l'épaisseur de la couche (210) de réglage du facteur de réflexion est dans une zone proche de la surface de contact avec la première électrode (107) plus grande que celle de l'autre zone.

13. Laser suivant la revendication 1 ou 4, dans lequel le deuxième miroir (104) est muni d'une ouverture (105) de courant ayant un plan en forme d'anneau de cercle concentrique et la superficie du cercle intérieur de l'ouverture (105) de courant est plus grande que la superficie en coupe de la couche (110) de réglage du facteur de réflexion.

14. Laser suivant l'une quelconque des revendications 1 à 13, dans lequel au moins une partie du résonateur (140) comprend une partie (130) analogue à une colonne.

15. Module de lumière comprenant un guide d'onde (1130, 1302) optique et le laser à semi-conducteurs à émission de surface revendiqué suivant l'une quelconque des revendications 1 à 14.

16. Dispositif de transmission de la lumière comprenant un module de lumière suivant la revendication 15.

17. Procédé de fabrication d'un laser à semi-conducteurs à. émission de surface comprenant un résonateur (140) formé sur un substrat (101) et émettant un faisceau laser dans une réaction perpendiculaire au substrat (101) à partir d'une surface (108) émettrice formée sur la surface supérieure du résonateur (140), dans lequel
(a) on forme un résonateur (140) sur le substrat (101) en formant un premier miroir (102), une couche (103) active et un deuxième miroir (104) comprenant la surface (108) émettrice comme partie de sa surface supérieure, de sorte que le premier miroir (102) et le deuxième miroir (104) prennent en sandwich la couche (103) active, le deuxième miroir (104) étant formé de manière à comprendre une couche ayant une épaisseur optique de m₁·λ/2, m₁ étant un nombre naturel supérieur ou égal à 1 et λ étant la longueur d'onde du faisceau laser,
**caractérisé en ce que**
(b) on forme une couche (110) de réglage du facteur de réflexion ayant une épaisseur optique de (2m₂-1)·λ/4, m₂ étant un nombre naturel égal ou supérieur à 1 sur la partie de la surface (108) émettrice où de la lumière est émise.

18. Procédé suivant la revendication 17, dans lequel le stade (b) comprend la formation d'un précurseur de la couche (110) de réglage du facteur de réflexion en éjectant une gouttelette sur la surface (108) émettrice et le durcissement ensuite du précurseur pour former la couche (110) de réglage du facteur de réflexion.

19. Procédé suivant la revendication 17 ou 18, dans lequel, en outre :
(c) on forme une première électrode (107) et une deuxième électrode (109) pour injecter un courant dans le résonateur (140), au moins une partie de la première électrode (107) est formée sur la surface supérieure du résonateur (140) et une ouverture est formée sur la surface supérieure du résonateur (140),
dans lequel, dans le stade (c), on forme la couche (110) de réglage du facteur de réflexion sur la surface (108) émettrice.
